# EUROPEAN PATENT SPECIFICATION

(11) **EP 0 400 728 B1**
(45) Date of publication and mention of the grant of the patent: **02.08.1995**
(21) Application number: 90201314.3
(22) Date of filing: 25.05.1990
(51) Int. Cl.: G11C 7/06, G11C 11/419

(54) **Integrated memory comprising a sense amplifier**
Integrierte Speicherschaltung mit einem Leseverstärker
Circuit intégré de mémorisation muni d'un amplificateur de lecture

(30) Priority: 31.05.1989 NL 8901376
(43) Date of publication of application: 05.12.1990
(73) Proprietor: Philips Electronics N.V., 5621 BA Eindhoven (NL)
(72) Inventor: Seevinck, Evert, NL-5656 AA Eindhoven (NL)
(74) Representative: Strijland, Wilfred

(56) References cited:
- FR-A- 2 340 598

## Description

The invention relates to an integrated field-effect transistor memory circuit comprising memory cells which are arranged in rows and columns, each column of memory cells being connected to a bit line and a non-bit line by way of selection means, and also comprising at least one sense amplifier which comprises a first and a second input for coupling to a bit line and an associated non-bit line of a column, each of which is coupled to a supply terminal via a load, which sense amplifier performs a current measurement on the first and the second input during the reading of information on the first and the second input, and which sense amplifier comprises a parallel connection of a first and a second current branch, each current branch comprising a control transistor having a gate, a source and a drain, the source of the control transistor in the first and the second current branch being connected to the first and the second input, respectively. A memory circuit of this kind is known from the article "Design tricks speed up INMOS's SRAMS" in "Electronics", April 16, 1987, p. 34. The cited article describes a memory circuit in which a sense amplifier senses and amplifies the information on bit lines by detection of current instead of detection of voltage differences. Consequently, the processing speed of such a sense amplifier is substantially independent of the parasitic bit line capacitance, so that a memory design may be simpler.

It is inter alia an object of the invention to provide an implementation of such an integrated memory circuit in which also the susceptibility to interference is less.

To achieve this, an integrated field-effect transistor memory circuit in accordance with the invention is characterized in that the gate of the control transistor (T1,T2) in each current branch is connected to the drain of the control transistor (T1,T2) in the other current branch, the channel of a load transistor (T3,T4), comprising a gate, a source and a drain, being connected in between the drain of the relevant control transistor (T1,T2) and a supply terminal (Vss) in each current branch, the load transistor (T3,T4) and the control transistor (T1,T2) in each current branch having their width/length ratio (W/L) substantially equal to each other, said load transistor (T3,T4) being of the same conductivity type as the control transistor (T1, T2) in the relevant current branch, the coupled gates of said load transistors (T3,T4) receiving a selection signal for the selective activation of the sense amplifier. An integrated memory in accordance with the invention offers the advantage that the sense amplifier is constructed using only 4 transistors, the 4 transistors providing full equalization of the voltages on the inputs of the sense amplifier.

An embodiment of an integrated memory in accordance with the invention is characterized in that the load transistor and the control transistor in each current branch are P-type transistors. Because bit lines in a memory are usually precharged to almost the positive supply voltage in order to sustain the data integrity of the memory cell during the reading of the cell, the absolute voltage difference between the gate and the source of the control transistor should be greater than the threshold voltage of this transistor. When instead of P-type N-type control transistors are used, therefore, the gate voltage should usually be higher than the positive supply voltage, thus necessitating the use of an additional circuit for generating said gate voltage.

Another embodiment of an integrated memory in accordance with the invention is characterized in that in each current branch a width/length ratio (W/L) of the load transistor is substantially equal to the width/length ratio (W/L) of the control transistor. Simulations performed on such a memory have demonstrated that the voltages on the gates of the control transistors are thus not latched to one of the voltages on the supply terminals. Consequently, a sense amplifier in an integrated memory in accordance with the invention is a self-restoring type, thus preventing the setting of one of the transistors from leaving the saturation region. Moreover, the implementation of such a sense amplifier on a chip is very simple.

Embodiments in accordance with the invention will be described in detail hereinafter with reference to a drawing; therein:
Fig. 1 shows an embodiment of a sense amplifier in accordance with the invention, and
Fig. 2 shows an embodiment of an integrated memory comprising several sense amplifiers in accordance with the invention.

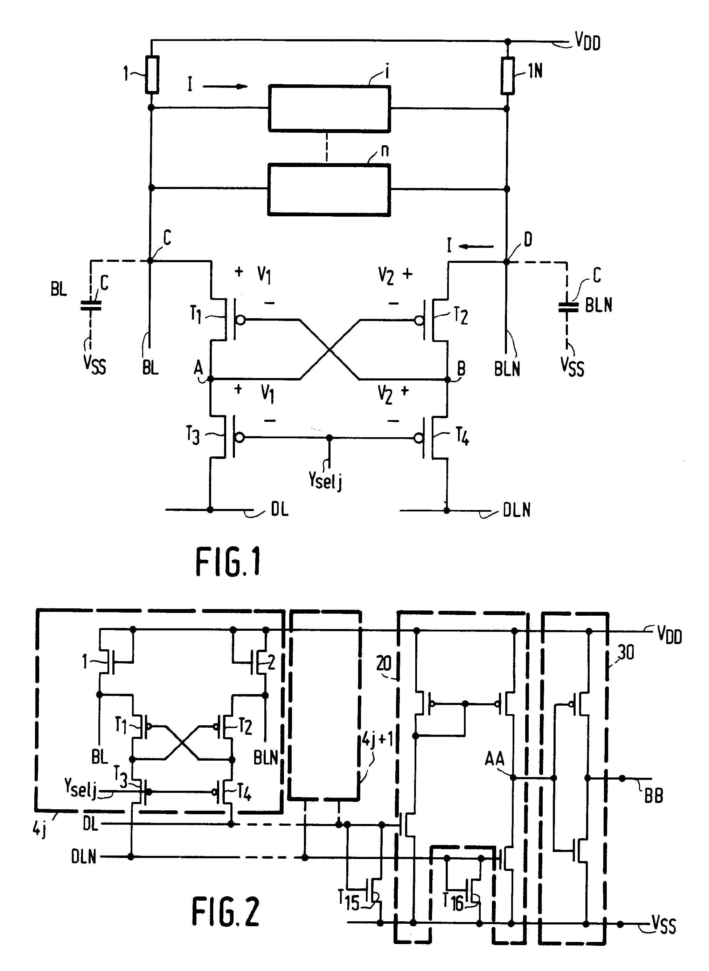

Fig. 1 shows an embodiment of a sense amplifier in accordance with the invention. The sense amplifier comprises 4 PMOS-transistors T1, T2, T3 and T4. The sources of the transistors T1 and T2 are connected to the first input C and the second input D, respectively, of the sense amplifier. The junction points C and D are also connected to bit lines BL and BLN of a memory column, which bit lines BL and BLN are each connected to the supply terminal VDD via a load 1 and a load 1N, respectively. A number of N memory cells, only two of which are shown in Fig. 1 for the sake of clarity, are connected to the bit lines BL and BLN. Using known techniques, a single memory cell in a memory column can be selected, that is to say by way of row selection transistors which connect the bit line and the non-bit line to the memory cell. The drain of the transistors T1 and T2 is connected to the source of the transistors T3 and T4, respectively, and to junction points A and B, respectively. The drains of the transistors T3 and T4 are connected to data lines DL and DLN, respectively. The gates of the transistors T3 and T4 receive a common selection signal YSELj. The selection signal YSELj selects a column j, where 1 ≦ j ≦ m. The gates of the transistors T1 and T2 are connected to the drains of the transistors T2 and T1, respectively. The bit lines BL and BLN have a parasitic bit line capacitance CBL and CBLN, respectively, shown in parallel between respective junction points C and D and the supply terminal VSS in Fig. 1.

The operation of the circuit shown in Fig. 1 is as follows: the bit lines BL and BLN are first charged via the loads 1 and 1N, so that the set voltage on the junction points C and D assumes a value between the voltages on the supply terminals VSS and VDD (usually approximately 4 V in the case of a supply voltage amounting to 5 V). Consequently, the junction points A and B carry a voltage which is one threshold voltage of the transistors T1 and T2 lower than the set voltage on the junction points C and D (approximately 3 V for a threshold voltage of approximately 1 V for a set voltage of approximately 4 V). When the selection signal YSEL is subsequently logic low, the transistors T3 and T4 are turned on. The transistors T1, T2, T3 and T4 are proportioned so that they are all operative in the saturation region when information on the bit lines BL and BLN is read by the sense amplifier. For substantially the same dimensions of the transistors T1 and T3, and T2 and T4, respectively, the voltage differences between the gate and the source of the transistors T1 and T3, and T2 and T4, respectively, are the same because of the equal currents through the transistors T1 and T3, and T2 and T4, respectively. For a voltage difference V1 and V2 between the gate and the source of the transistors T1 and T3, and T2 and T4, respectively, the junction points A and B carry a voltage V1 and V2, respectively (selection signal YSELj is logic low). The gate of the respective transistor T1 and T2 thus carries a voltage V2 and V1, respectively. The junction points C and D thus carry a voltage (V1 + V2). After the selection of a single memory cell i in the column j, either the junction point C or the junction point D will be slightly discharged by a discharge current I, depending on the information in the memory cell i. By way of example it is assumed in Fig. 1 that the junction point C is slightly discharged. The voltage on the junction point C slightly decreases due to the discharge current I. Because the voltages on the junction points C and D, however, are maintained equal by the sense amplifier in accordance with the invention (equalization effect), the sense amplifier also decreases the voltage on the junction point D to the same extent as the voltage decrease on the junction point C. Said voltage decrease on the junction point D is realised by way of a discharge current I. The difference between the drain currents of the transistors T3 and T4 amounts to the current I, being equal to the discharge current I of the memory cell i. Because of the intrinsic equalization effect on the voltages on the junction points C and D (being connected to the bit lines BL and BLN), a sense amplifier in accordance with the invention offers the advantage that the sensing delay of the sense amplifier is substantially independent of the bit line capacitance CBL or CBLN, because no or substantially no discharging of the bit line capacitance is required for reading the information in the memory cell i.

Simulations performed on a sense amplifier in accordance with the invention have demonstrated that for substantially the same width/length ratios (W/L) of the transistors T1 and T3, and T2 and T4, respectively, the voltages on the junction points A and B are not latched to one of the voltages on the supply terminals. This offers the advantage that a sense amplifier in accordance with the invention is self-restoring, so that the setting of the transistor T3 or T4 will not leave the saturation region.

There are two ways of deriving an output signal from the sense amplifier: first of all by measurement of a voltage difference on the junction points A and B, and secondly via difference in currents through the first current branch, via the transistors T1 and T3, to the data line DL and through the second current branch, via the transistors T2 and T4, to the non-data line DLN.

In the first case a voltage difference will occur between the junction points A and B due to the appearance of a difference current I through the transistors T3 and T4. For a further amplification the junction points A and B may be connected to a further sense amplifier stage, in which case the drains of the transistors T3 and T4 can be connected to the supply terminal VSS.

In the second case the currents through the transistors T3 and T4 can be applied to a second amplifier stage, via the data lines DL and DLN, in which a current difference can be converted into a voltage difference.

Fig. 2 shows an embodiment of an integrated memory in accordance with the invention which comprises several sense amplifiers 4j, 4j+1 etc, whose output signals are applied to the data lines DL and DLN via mutually different currents. Elements in Fig. 2 which correspond to elements of Fig. 1 are denoted by corresponding references. The outputs of the sense amplifiers 4j, 4j+1 etc. are connected to common data lines DL and DLN. The sense amplifiers 4j+1 etc. are constructed in the same way as the sense amplifier 4j. The memory cells i in the column j and the bit line capacitances CBL and CBLN have been omitted in Fig. 2 for the sake of clarity, but are indeed present in the circuit. The loads 1 and 1N of Fig. 1 consist of NMOS-transistors 1 which are connected as diodes. However, they may alternatively be formed by PMOS-transistors connected as diodes. Between each of the data lines DL and DLN and the supply terminal VSS there is included an NMOS-transistor T15, T16, respectively, connected as a diode. Furthermore, a further amplifier stage 20 is connected to the data lines DL and DLN. A buffer circuit 30 is connected to output AA of the amplifier stage 20, which buffer circuit produces an output signal on output BB.

The operation of the circuit shown in Fig. 2 is as follows: after the selection of a single desired sense amplifier 4j in a memory column j by means of a selection signal YSELj, the information is transferred from a selected memory cell i in the relevant column j to the data lines DL and DLN by way of currents which are mutually different. The currents through the data lines DL and DLN are applied to the supply terminal VSS by means of the transistors T15 and T16, said currents being converted into voltages because of the diode effect of T15 and T16. Because the value of the currents through the data lines DL and DLN differs (i.e. the current I), different voltages are applied to the inputs of the further amplifier stage 20. The input signals are further amplified in the amplifier stage 20 and applied, via the output AA, to a buffer circuit 30. The buffer circuit 30 outputs an output signal having CMOS output levels on the output BB.

## Claims

1. An integrated field-effect transistor memory circuit comprising memory cells (i..n) which are arranged in rows and columns, each column of memory cells (i..n) being connected to a bit line and a non-bit line by way of selection means, and also comprising at least one sense amplifier which comprises a first and a second input (C,D) for coupling to a bit line and an associated non-bit line of a column, each of which is coupled to a supply terminal (VDD) via a load (1,1N), which sense amplifier performs a current measurement on the first and the second input (C,D) during the reading of information on the first and the second input (C,D), and which sense amplifier comprises a parallel connection of a first and a second current branch (T1,T3;T2,T4), each current branch (T1,T3;T2,T4) comprising a control transistor (T1,T2) having a gate, a source and a drain, the source of the control transistor (T1,T2) in the first and the second current branch being connected to the first and the second input (C,D), respectively, characterized in that the gate of the control transistor (T1,T2) in each current branch is connected to the drain of the control transistor (T1 ,T2) in the other current branch, the channel of a load transistor (T3,T4), comprising a gate, a source and a drain, being connected in between the drain of the relevant control transistor (T1,T2) and a supply terminal (Vss) in each current branch, the load transistor (T3,T4) and the control transistor (T1,T2) in each current branch having their width/length ratio (W/L) substantially equal to each other, said load transistor (T3,T4) being of the same conductivity type as the control transistor (T1, T2) in the relevant current branch, the coupled gates of said load transistors (T3 ,T4) receiving a selection signal for the selective activation of the sense amplifier.

2. An integrated field-effect transistor memory circuit as claimed in Claim 1, characterized in that the load transistor (T3,T4) and the control transistor (T1,T2) in each current branch are P-type transistors.

3. An integrated field-effect transistor memory circuit as claimed in Claim 1 or 2, comprising several sense amplifiers (4j, 4j+1) which are connected to the same data bus (DL,DLN) at the output side, characterized in that between the data bus (DL, DLN) and a supply terminal (Vss) there is included a field-effect transistor (T15) which is connected as a diode.

## Patentansprüche

1. Integrierte Feldeffekttransistor-Speicherschaltung mit in Zeilen und Spalten angeordneten Speicherzellen (i...n), wobei jede Spalte aus Speicherzellen (i...n) über Selektionsmittel mit einer Bitleitung und einer Nicht-Bitleitung verbunden ist, sowie mit mindestens einem Leseverstärker, der einen ersten und einen zweiten Eingang (C, D) zum Koppeln mit einer Bitleitung und einer zugehörigen Nicht-Bitleitung einer Spalte umfaßt, von denen jeder über eine Last (1, 1N) mit einem Versorgungsanschluß (VDD) gekoppelt ist, wobei der Leseverstärker während des Lesens von am ersten und am zweiten Eingang (C, D) vorhandenen Informationen eine Strommessung am ersten und am zweiten Eingang (C, D) ausführt, und wobei der Leseverstärker eine Parallelschaltung aus einem ersten und einem zweiten Stromzweig (T1, T3; T2, T4) enthält, wobei jeder Stromzweig (T1, T3; T2, T4) einen Steuertransistor (T1, T2) mit einem Gate, einer Source und einem Drain umfaßt, wobei die Source des Steuertransistors (T1, T2) im ersten und im zweiten Stromzweig mit dem ersten bzw. zweiten Eingang (C, D) verbunden ist, dadurch gekennzeichnet, daß das Gate des Steuertransistors (T1, T2) in jedem Stromzweig mit dem Drain des Steuertransistors (T1, T2) in dem anderen Stromzweig verbunden ist, in jedem Stromzweig der Kanal eines Lasttransistors (T3, T4), welcher ein Gate, eine Source und ein Drain hat, zwischen den Drain des betreffenden Steuertransistors (T1, T2) und einen Versorgungsanschluß (Vss) geschaltet ist, wobei das Breiten/Längenverhältnis (W/L) des Lasttransistors (T3, T4) und des Steuertransistors (T1, T2) in jedem Stromzweig nahezu einander gleich sind, der genannte Lasttransistor (T3, T4) vom gleichen Leitungstyp wie der Steuertransistor (T1, T2) in dem betreffenden Stromzweig ist und die gekoppelten Gates der genannten Lasttransistoren (T3, T4) ein Selektionssignal zur selektiven Aktivierung des Leseverstärkers empfangen.

2. Integrierte Feldeffekttransistor-Speicherschaltung nach Anspruch 1, dadurch gekennzeichnet, daß der Lasttransistor (T3, T4) und der Steuertransistor (T1, T2) in jedem Stromzweig p-Transistoren sind.

3. Integrierte Feldeffekttransistor-Speicherschaltung nach Anspruch 1 oder 2, mit mehreren Leseverstärkern (4j, 4j+1), die an der Ausgangsseite mit dem gleichen Datenbus (DL, DLN) verbunden sind, dadurch gekennzeichnet, daß zwischen dem Datenbus (DL, DLN) und einem Versorgungsanschluß (Vss) ein als Diode geschalteter Feldeffekttransistor (T15) enthalten ist.

## Revendications

1. Circuit intégré de mémoire à transistors à effet de champ comprenant des cellules de mémoire (i...n) qui sont agencées en rangées et colonnes, chaque colonne de cellules de mémoire (i...n) étant connectée à une ligne de bit et à une ligne de non-bit à l'aide de moyens de sélection, et comprenant également au moins un amplificateur de lecture qui comprend une première et une deuxième entrées (C, D) à coupler à une ligne de bit et à une ligne de non-bit associée d'une colonne, chacune d'elles étant couplée à une borne d'alimentation (V_{DD}) via une charge (1, 1N), ledit amplificateur de lecture effectuant une mesure de courant sur la première et la deuxième entrées (C, D) au cours de la lecture des informations sur la première et la deuxième entrées (C, D), ledit amplificateur de lecture comprenant, en outre, un montage en parallèle d'une première et d'une deuxième branches de courant (T1, T3; T2, T4), chaque branche de courant (T1, T3; T2, T4) comprenant un transistor de commande (T1, T2) comportant une grille, une source et un drain, la source du transistor de commande (T1, T2) de la première et de la deuxième branches de courant étant connectée à la première et à la deuxième entrées (C, D), respectivement, caractérisé en ce que la grille du transistor de commande (T1, T2) dans chaque branche de courant est connectée au drain du transistor de commande (T1, T2) dans l'autre branche de courant, le canal d'un transistor de charge (T3, T4) comprenant une grille, une source et un drain étant connecté entre le drain du transistor de commande en question (T1, T2) et une borne d'alimentation (V_{SS}) de chaque branche de courant, le transistor de charge (T3, T4) et le transistor de commande (T1, T2) de chaque branche de courant ayant un rapport largeur/longueur (1/L) sensiblement égal, ledit transistor de charge (T3, T4) étant du même type de conductivité que le transistor de commande (T1, T2) dans la branche de circuit concernée, les grilles couplées desdits transistors de charge (T3, T4) recevant un signal de sélection pour l'activation sélective de l'amplificateur de lecture.

2. Circuit intégré de mémoire à transistors à effet de champ selon la revendication 1, caractérisé en ce que le transistor de charge (T3, T4) et le transistor de commande (T1, T2) de chaque branche de courant sont des transistors de type P.

3. Circuit intégré de mémoire à transistors à effet de champ selon la revendication 1 ou 2, comprenant plusieurs amplificateurs de lecture (4j, 4j+1) qui sont connectés au même bus de données (DL, DLN) du côté de sortie, caractérisé en ce qu'entre les bus de données (DL, DLN) et une borne d'alimentation (V_{SS}) est inclus un transistor à effet de champ (T15) qui est connecté en diode.
